Europäisches Patentamt

European Patent Office

Office européen des brevets

(19)

(11) Publication number: **0 197 730**
**A2**

(12) # EUROPEAN PATENT APPLICATION

(21) Application number: **86302333.9**

(22) Date of filing: **27.03.86**

(51) Int. Cl.⁴: **H 01 L 27/08**

(30) Priority: **29.03.85 US 717349**

(43) Date of publication of application:
**15.10.86 Bulletin 86/42**

(84) Designated Contracting States:
**AT BE CH DE FR GB IT LI LU NL SE**

(71) Applicant: **ADVANCED MICRO DEVICES, INC.**
**901 Thompson Place P.O. Box 3453**
**Sunnyvale, CA 94088(US)**

(72) Inventor: **Kuang-Yeh, Chang**
**248 Bacigalupi Drive**
**Los Gatos California 95030(US)**

(72) Inventor: **Liu, Yow-Juang**
**350 St. Julie Drive**
**San Jose California 95119(US)**

(74) Representative: **Wright, Hugh Ronald et al,**
**Brookes & Martin 52/54 High Holborn**
**London WC1V 6SE(GB)**

(54) **Latch-up resistant integrated circuit and method of manufacture.**

(57) A complementary metal-oxide semiconductor (CMOS) circuit device exhibits latch-up resistance improvement by an order of magnitude when fabricated such that drain regions of complementary transistors are adjacently spaced in parallel planes with their respective source regions outlying the complementary pair in mutual parallel planes to said drain planes; the gates of the transistors are formed accordingly and generally lie over their respective channel regions in mutual parallel planes to said source planes and drain planes. Ideally, the circuit biasing potential and the ground reference potential electrodes are connected to the source regions; the output signal is pulled from the drains at the center of the structure.

## LATCH-UP RESISTANT        INTEGRATED CIRCUIT
## AND METHOD OF MANUFACTURE

The present invention generally relates to integrated circuits having greatly improved resistance to the latch-up phenomena.

Metal-oxide semiconductor technology has become one of the most rapidly expanding fields in the fabrication of integrated circuit devices. MOS field effect transistors (MOSFET) are a natural choice for digital applications because of their ON-mode/OFF-mode method of operation. CMOS structures, having both n-channel and p-channel devices available on the same chip, are particularly attractive because of their exceedingly low power dissipation and high packing density capabilities.

Because in CMOS devices both n-channel and p-channel components are being built into the same substrate, junction isolation is necessary for the device which is of the same conductivity type as the substrate. Basically, this is accomplished by providing wells in the substrate having a conductivity type opposite that of the substrate. The device of the same conductivity type as the substrate        can be formed in such a well. For example, an n-well is formed in a p-type substrate where p-channel devices are to be subsequently constructed.

However, the use of such a structure forms parasitic bipolar transistors; in the example, the p-type substrate, the n-well, and the subsequently embedded p+ doped regions of the p-channel device form an undesirable pnp-type bipolar transistor. The combination of the two types of devices in such close proximity gives rise to mutual influence and tends to form silicon controlled rectifiers (SCR), which can trigger the ON state of the devices when the integrated circuit's reference biasing voltage changes (due to phenomenon such as temperature gradients, electrical noise pulses, or ionizing radiation). Once triggered, the effect is to cause the circuit to "latch-up." Latch-up causes a CMOS integrated circuit to try to short out the power supply. To cure a latch-up condition, the shorted power must be disconnected. The tendancy toward latch-up increases with circuit density, hence, LSI and VLSI are difficult to achieve. The present invention is directed toward this inherent problem of CMOS integrated circuit latch-up.

A CMOS circuit has a resistance to the latch-up phenomena which is a direct function of the "holding current." The holding current, Ih, is the minimum current required to maintain a switching device in a closed or conducting state after it is energized or triggered. In current CMOS devices fabricated on wafers not having an epitaxial layer, Ih is approximately 2-3 ma.

One prior art method of dealing with the latch-up problem is the use of "groove isolation" as taught by Haskell in U.S. Patent No. 4,495,025, assigned to the present applicant. This is a technique which incorporates isolation trenches to minimize p-n junction leakage currents and positive feedback latch-up conditions. See also, U.S. Patent No. 4,486,266 to T. Yamaguchi.

Another method of altering CMOS structures to reduce latch-up events is to use an insulating layer of sapphire to insulate and separate all components such that the well junction isolation is not needed. See U.S. Patent No. 4,484,209. U.S. Patent No. 4,416,050 to Temecula similarly teaches a dielectric isolation method using oxide layers between silicon islands in which the devices are built.

Another popular approach has been the use of conductive guard rings around the individual devices to affect the circuit parameters and reduce the gain factor of the parasitic SCRs.

Each of these techniques bears the same penalties of using valuable die space which could otherwise be dedicated to additional circuit components or requiring extraordinarily complicated process steps.

We will describe a CMOS structure having an exceedingly improved resistance to the latch-up phenomena.

We will also describe latch-up resistant CMOS integrated circuit devices having reduced device geometries and increased performance.

We will also describe a simple method of manufacturing a latch-up resistant CMOS integrated circuit device.

We will also describe a method for fabricating latch-up resistant CMOS integrated circuits having reduced device geometries and increased performance.

In one aspect, the present invention provides a latch-up resistant CMOS integrated circuit device, having a substrate and at least one p-channel transistor and at least one n-channel transistor configuration, in which latch-up resistance is a function of the holding current, Ih, wherein the drain regions of said transistors lie in an adjacently spaced parallel configuration in said substrate, the source regions of said transistors lie in a spaced parallel configuration outlaying said drain regions, and the gates of said transistors are in a space parallel configuration superposing said substrate. To optimize the resistance to latch-up, the output of the circuit is drawn from the drain regions between the gates.

Another aspect of the invention is the provision of a method for producing a latch-up resistant complementary metal-oxide semiconductor (CMOS) circuit in a substrate of a first conductivity type, by: forming a region of a second conductivity type embedded in said substrate; forming a first gate over said substrate and a second gate over said embedded region, such that said gates have their respective longitudinal axes lying in first parallel planes; forming a first source region in said substrate on the side of said first gate which is furthest from said embedded region and forming a first drain region in said substrate on the side of said first gate electrode nearest said embedded region, such that said first source region and said first drain region have their respective longitudinal axis lying in second parallel planes which straddle the plane of said first gate; forming a second drain region in said embedded region on the side of said second gate which is nearest said first drain region; and forming a second source region in said embedded region on the side of said second gate electrode distal from said first source region, such that said second drain region and said second source region have their respective longitudinal axes lying in third parallel planes which straddle the plane of said second gate, whereby said first, second and third parallel planes are mutually parallel.

Other objects, features and advantages of the present invention will become apparent upon consideration of the following detailed description and the accompanying drawings, in which like reference designations represent like features throughout the figures.

## BRIEF DESCRIPTION OF THE DRAWINGS

FIGURE 1 is a plan view (top) of a typical layout schematic for a conventional, prior art CMOS inverter integrated circuit structure;

FIGURE 2a is a plan view (top) of the layout schematic according to the present invention of an n-well CMOS inverter integrated circuit structure;

FIGURE 2b is a plan view (top) of the layout schematic according to the present invention as shown in FIGURE 2A in a preferred orientation of substrate and well pick-ups;

FIGURE 3 is a electrical schematic diagram of the circuit as shown in FIGURES 1 and 2;

FIGURE 4a is a plan view (top) of an alternative embodiment according to the present invention as shown in FIGURE 2;

FIGURE 4b is a plan view (top) of the layout schematic according to the present invention as shown in FIGURE 4a in an alternative orientation of the substrate and well pick-ups;

FIGURE 5 is a plan view (top) of another alternative embodiment according to the present invention as shown in FIGURE 2;

FIGURE 6 is a plan view (top) of another alternative embodiment according to the present invention as shown in FIGURE 2;

FIGURE 7 is a plan view (top) of the layout schematic according to the present invention of a p-well CMOS inverter integrated circuit structure;

FIGURES 8-13 are cross-sectional drawings showing a process sequence for the method of manufacture according to the present invention for the embodiment as shown in FIGURE 2, section A-A;

FIGURE 14 is a graphical representation of empirical data, showing a plot of holding current vs. various alternative structural layouts for the device of FIGURE 2;

FIGURE 15 is a graphical representation of empirical data, showing a plot of holding current vs. various alternative structural layouts for the device of FIGURE 2 as embodied on an epitaxial wafer;

FIGURE 16 shows a plan view (top) of the prior art device as shown in FIGURE 1 and a plot of holding current vs. various output electrode combinations designated in the view; and

FIGURE 17 shows a plan view (top) of the structure of the present invention as shown in FIGURE 2 and a plot of holding current vs. various output electrode combinations designated in the view.

## DETAILED DESCRIPTION OF THE PRESENT INVENTION

Reference is now made in detail to a specific embodiment of the present invention, which illustrates the best mode presently contemplated by the inventors for practicing the invention. Alternative embodiments are also briefly described and set forth in the accompanying drawings. The drawings referred to in this description are understood not to be drawn to scale. It is especially important to note that only one circuit device, an inverter, has been used to exemplify the invention. The drawings are intended to illustrate only one portion of an integrated circuit fabricated in accordance with the present invention.

Any of the conventional integrated circuit fabrication techniques, such as CVD, PECVD, ion-implantation, etc., may be employed throughout the formation steps. Oxidation, diffusion, and metallization steps to fabricate FETs are well-known and understood in the art and there is no need to elaborate in order for one skilled in the art to understand the present invention. The test devices of the present invention were fabricated in conventional 1.5 micron technology using commercially available diffusion and implant machines.

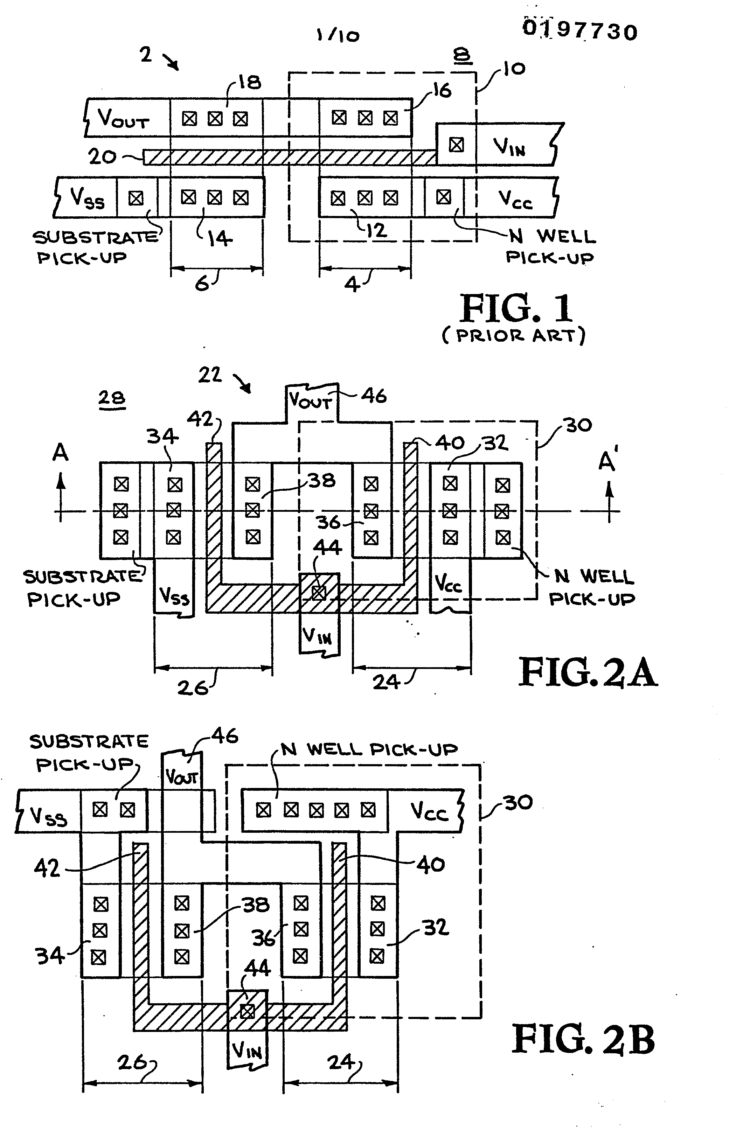

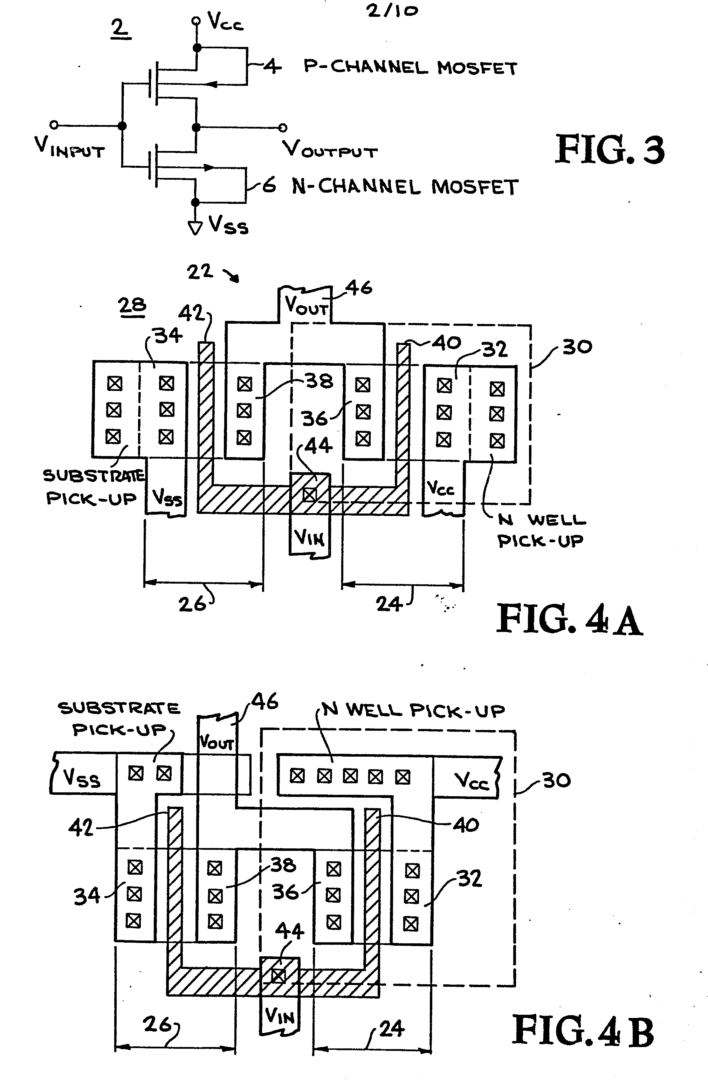

In order to demonstrate the best mode for practicing the invention, a comparison is demonstrated to a conventional CMOS inverter integrated circuit device 2 as shown in FIGURE 1 (key layers only). The electrical equivalent schematic is shown in FIGURE 3. The inverter is the basic building block of the most complex CMOS arrays now in use. It is important to keep in mind that the teaching herein applies equally to other building blocks, such as logic gates, comparators and memory cells of digital logic integrated circuits.

A p-channel MOSFET 4 and n-channel MOSFET 6 are known to perform the inverter function when operably coupled in the series common-gate configuration as shown. In operation with a biasing voltage, Vcc, at 5 volts, the p-channel MOSFET 4 is turned OFF and the n-channel MOSFET 6 is turned ON for a Vin of 5 volts. This operation reverses for Vin at O volts. In either of these two stable conditions, since one of the MOSFETs is in a very high-impedance OFF state, the combination will draw almost no steady-state current. Virtually no power dissipation occurs.

Referring to FIGURE 1, into the substrate 8 of a first conductivity type (p in this example), a well 10 of a second conductivity type (n) was implanted to form a region where a device, such as a FET of the first conductivity type, was constructed.

The source region 12 of the p-MOSFET 4 is normally implanted to lie in the same plane as that of the source region 14 of the n-MOSFET 6. Similarly, the drain region 16 of the p-MOSFET 4 and the drain region 18 of the n-MOSFET 6 are normally implanted to lie in another single plane which is parallel to said source plane. The gate region 20 for each transistor is then constructed in a single plane which is between said sources plane and drain plane. The input, output, and biasing pick-ups are labelled accordingly.

According to the present invention, in order to minimize the latch-up phenomena, this configuration must be abandoned. Referring specifically to FIGURE 2a and using the same exemplary inverter device of FIGURE 3, an n-well 30 is embedded in substrate 28 where the p-channel MOSFET 24 is to be formed. The source region 32 of the p-MOSFET 24 and the source region 34 of the n-MOSFET 26 in the substrate 28 are implanted to lie in parallel planes. Similarly, the drain region 36 of the p-MOSFET 24 in the well and the drain region 38 of the n-MOSFET 26 in the substrate are implanted to lie in parallel planes which are mutually parallel to their respective source regions 32, 34. The source/drain channel regions of each transistor are automatically oriented in parallel planes straddled by the respective source/drain planes of each. The gate 40 of the p-MOSFET 24 and the gate 42 of the n-MOSFET 26 are formed over the respective channel regions so as to be properly aligned and in planes which are parallel to each other and to the above-said source planes and drain planes viz., basically in the same planes as the respective channel planes.

Since for this inverter device the gates 40, 42 are coupled in common, they are shown joined into a single structure at gate pick-up electrode 44. The substrate and well pick-ups shown in the various configuration of FIGURES 2 and 4-7 are positioned in arbitrary locations which are not critical to the invention. The substrate and well pick-up positions can be determined in accordance with the most efficient geometry of the particular device in which the present invention is to be practiced. However, it is generally preferred in accordance with the present invention to keep each such pick-up in a location which is as near as possible to the complementary side of the device as shown, for example, in FIGURES 2b and 4b. In these configurations the substrate and well pick-ups can be shared by adjacent devices in the die. Moreover, the drain regions 36, 38 are implanted such that their parallel planes lie adjacently spaced between the parallel planes defined by the gates 40, 42, respectively. Hence, the planes defined by the sources 32, 34 are on the outboard regions of the device 22.

Note also that the output, Vout, taken at metal layer 46 is pulled from both drains 40, 42 in the inboard region of the device 22. As discussed below, this further increases latch-up resistance. Both the biasing potential, Vcc and the ground reference, Vss, are separated by the gates 40, 42 and coupled outboard of the source regions 34, 32, respectively.

This novel structure appears to minimize latch-up due to the following mechanism. The two inside drains behave like bipolar transistor collectors in the layout taught by the present invention. The n-channel device drain 34 performs the function of an npn collector. The p-channel device drain 36 performs the function of a pnp collector. Hence, a lot of current is collected and depletes the effective current which otherwise would cause latch-up.

Another inherent advantage of this layout, as compared to the prior art, is that without physically separating the two CMOS transistors further away from each other, the p+ to n+ spacing between sources is automatically increased by two drain widths plus two gate widths.

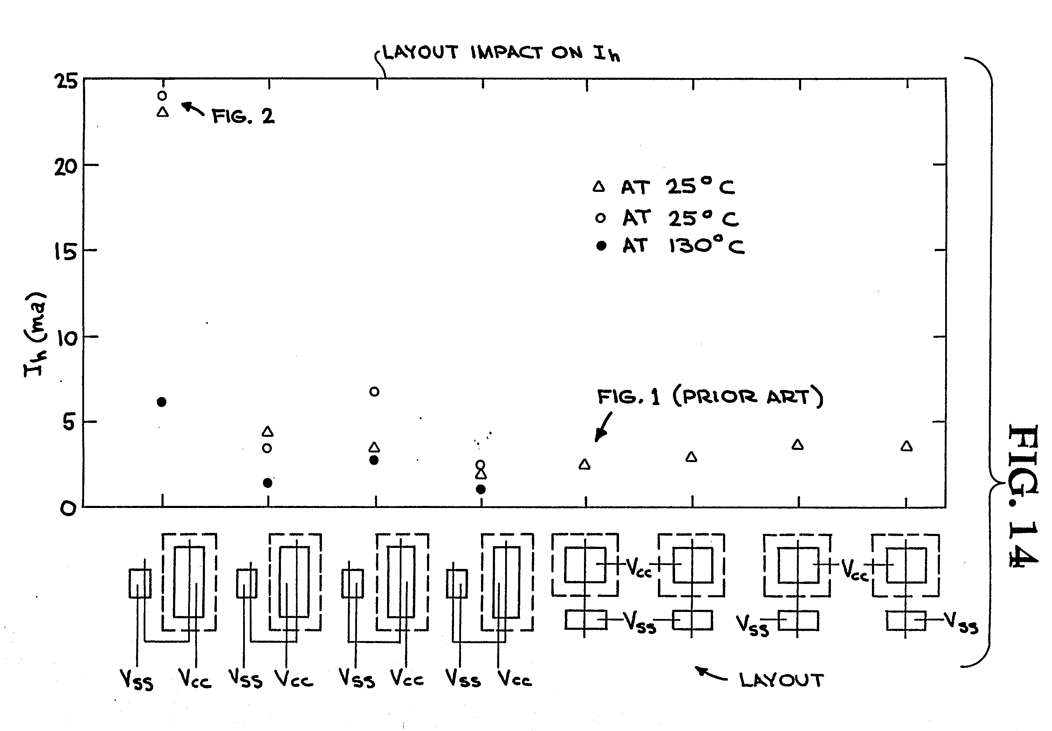

FIGURE 14 is a graphical representation of empirically measured values of holding current, Ih, for eight perturbations of the structural layout for a CMOS inverter integrated circuit. The circuit according to the present invention as shown in FIGURE 3 increases the holding current by approximately one order of magnitude over that of FIGURE 1.

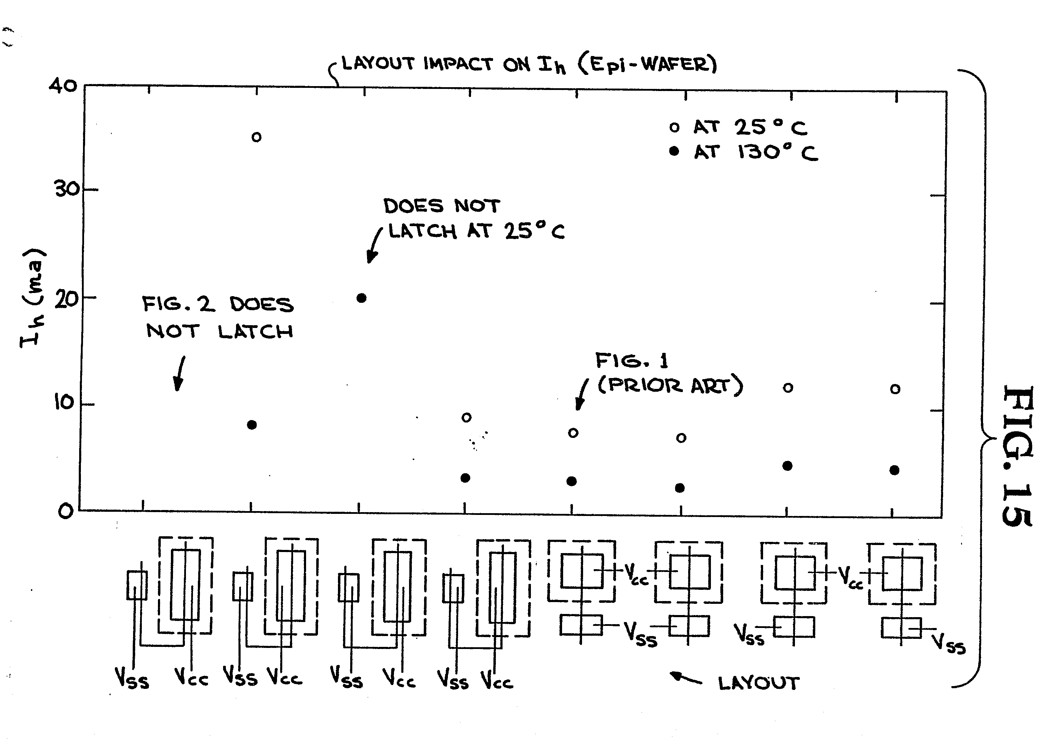

FIGURE 15 is a graphical representation of the same nature as that shown in FIGURE 14, only the circuits were fabricated on an epitaxially grown wafer/substrate. For devices processed onto epitaxial wafers, this will increase the holding current by approximately another order of magnitude due to the increased p+ to n+ spacing between sources. Notice that the circuit fabricated in accordance with the present invention as shown in FIGURE 3 did not latch-up under typical operating extremes.

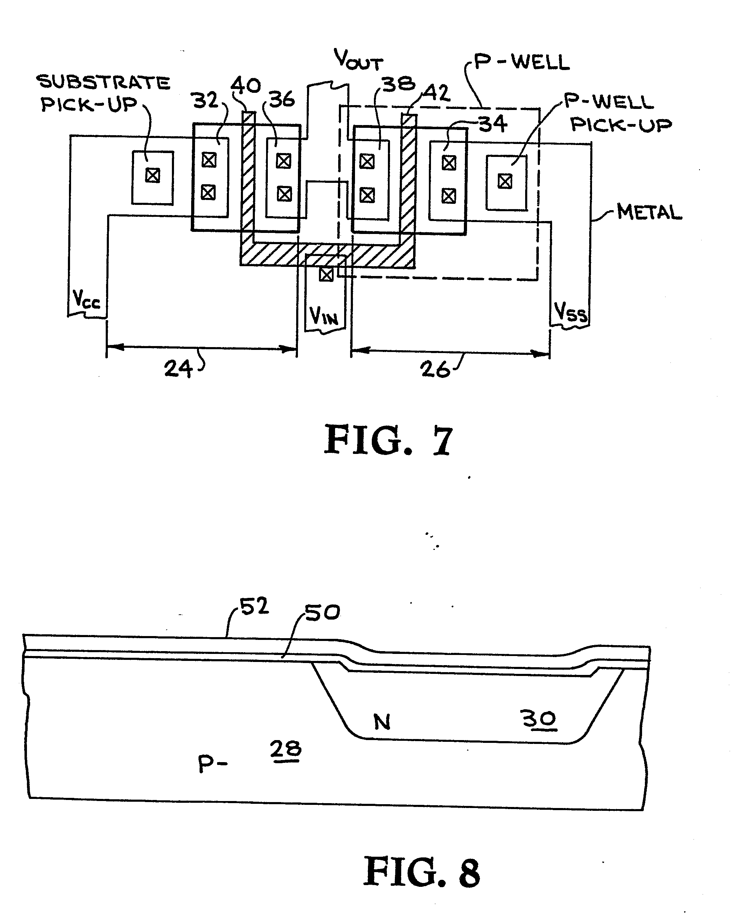

FIGURES 8-13 illustrate in cross-section idealized, sequential processing steps of the present invention along line A-A of FIGURE 2.

FIGURE 8 is a view of a semiconductor structure which includes a lightly doped p-conductivity type substrate 28 and an n-conductivity type well 30 formed therein. On the upper surface of the substrate 28 a relatively thin insulator layer 50 (on the order of approximately 150 to 500 Angstroms) of silicon dioxide has been formed. A typical technique for forming the oxide 50 is by heating the underlying substrate to a temperature in the range of approximately 800 to 1100 degrees centigrade for a time sufficient to build-up a desired thickness in an oxygen ambient.

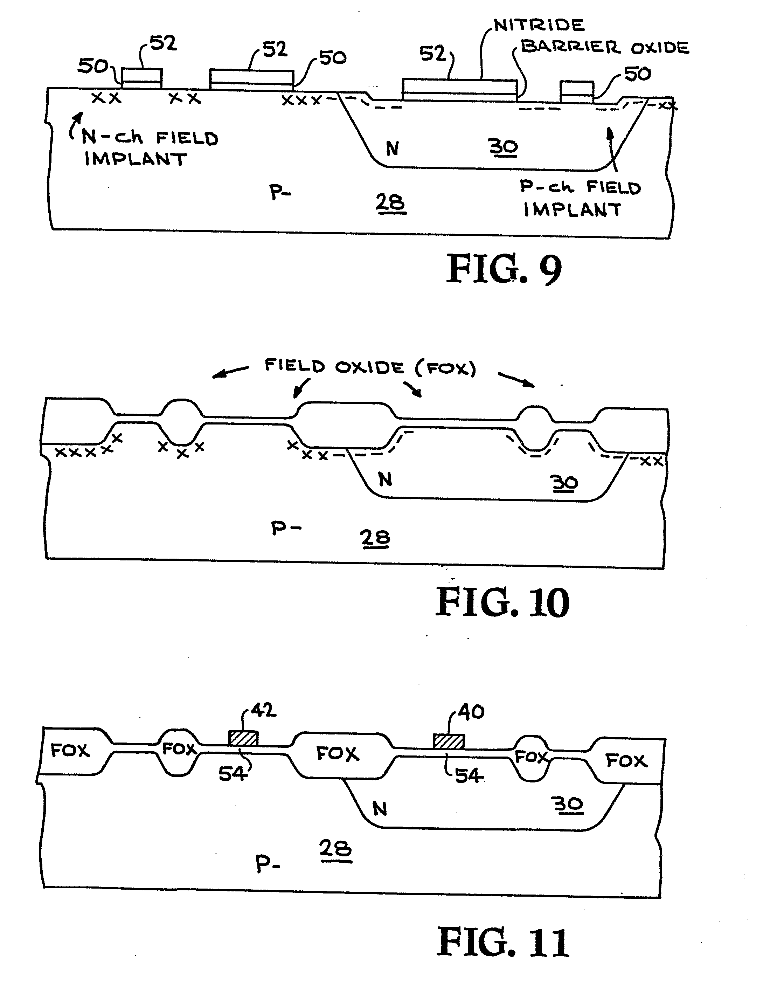

FIGURE 9 and 10 are cross-sectional views of further stages of the fabrication; and example of the details of the steps of this stage of the process are explained in U.S. Patent No. 4,481,705 (HASKELL), PROCESS FOR DOPING FIELD ISOLATION REGIONS IN CMOS INTEGRATED CIRCUITS, assigned to the common assignee of the present invention, and incorporated herein by reference (the field implant in the well is optional).

FIGURE 11 shows the structure at step completion after a thin gate oxide layer 54 (on the order of 250 Angstroms) has been grown according to conventional methods. A common technique can be employed to form the polysilicon gates 40, 42 of the circuit device such as by using a photoresist mask to pattern the layer of deposited polysilicon used to define the gates 40, 42 of the transistors.

Referring briefly to FIGURES 1 and 2a, it can be seen that a crucial difference between the prior art and the present invention lies in the gate structure defined in this step. As set forth above, the empirical study of the present invention was conducted in 1.5 micron technology (channel length defined). All dimensions of the structure will be directed accordingly with the size technology chosen. In other words, channel length and width are not a limitation to this process or structure. CMOS devices of any size can be layed out in accordance with the present invention and similar results will be obtained. Hence, no further exposition of other specific dimensions is warranted in order to practice the invention.

Forming the p-MOSFET gate 40 in a plane parallel to the n-MOSFET gate 42 (as best seen in FIGURE 2) is a step, which when coupled with the similar parallel plane geometry for the source and drain implants as shown in FIGUREs 2, 4-6, 12 and 13, results in greatly increased resistance to latch-up.

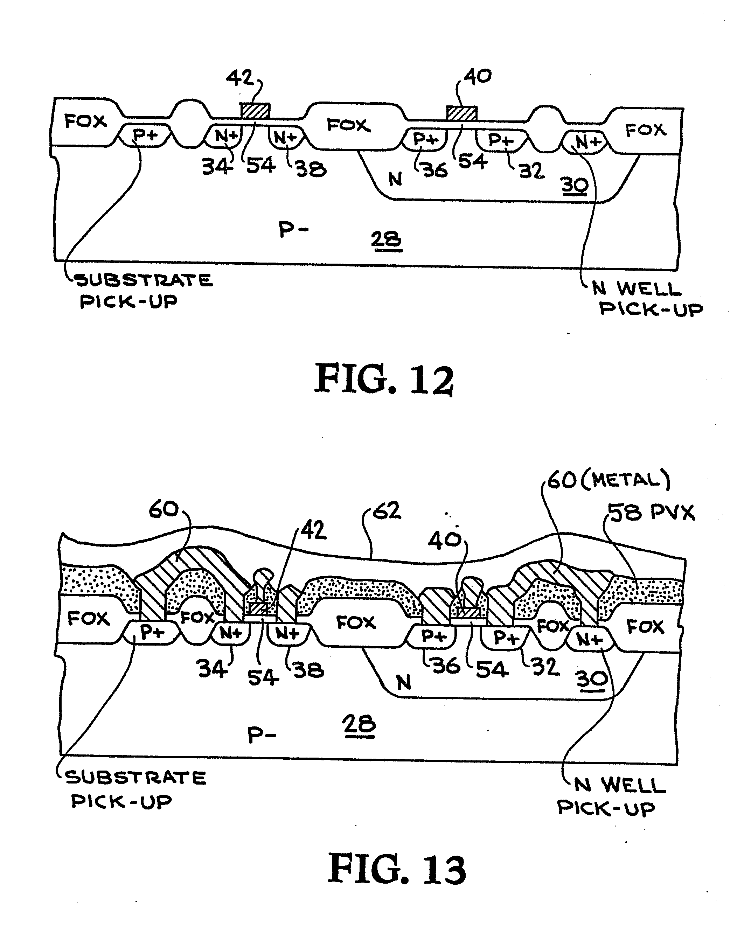

FIGURE 12 provides the cross-section of the structure at step completion after the implantation of the p-MOSFET 24 source 32, drain 36 and n+ conductivity type n-well pick-up and the n-MOSFET 26 source 34, drain 38 and p+ conductivity type substrate pick-up. Again as in the gate formation, the forming of these regions in mutually parallel planes with the drain regions adjacently spaced and the source regions outlaying the drains and gates results in greatly increased resistance to latch-up.

FIGURE 13 shows the cross-section of the structure after final step completion showing insulator layers 58, metal interconnects 60 and a passivation topside layer 62 formed in accordance with conventional techniques. Note that the output, Vout, is pulled from the drains 36, 38 from between the gate planes. As shown in FIGURE 15, this structure when formed on an epitaxially grown wafer substrate, did not latch-up at all under test conditions.

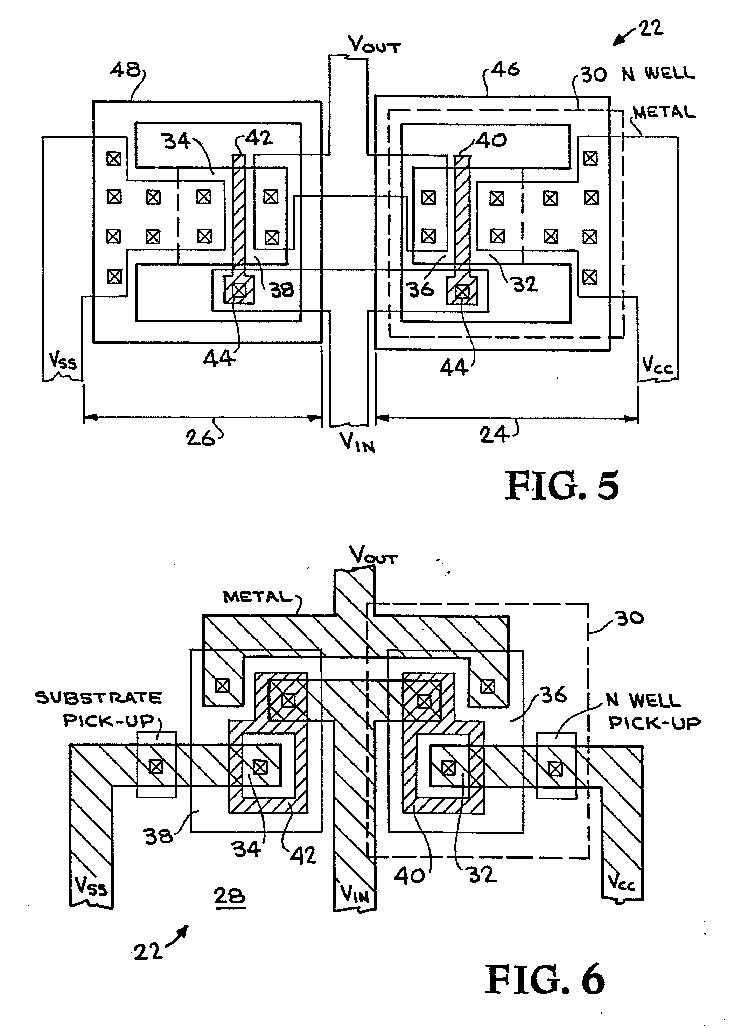

This method appears to be universal. It can be used to fabricate many CMOS circuit layouts to obtain the same orders of effect. Using the n-well process as an example, alternative inverter circuits are shown in FIGURE 4 (butting contacts), FIGURE 5 (additional guard rings), and FIGURE 6 (donut transistors). The same concept also can be applied to p-well (FIGURE 7) or other CMOS processes.

The application of the present invention has also been found to apply to a "donut" structure CMOSFET device as is shown in FIGURE 6. Notice in this particular inverter circuit device that although the respective source regions 32, 34, the drain regions 36, 38 and the gates 40, 42 can not be described or defined by mutual parallel plane geometry, the basic structure of having at least a portion of the respective drains inboard of the respective sources is maintained.

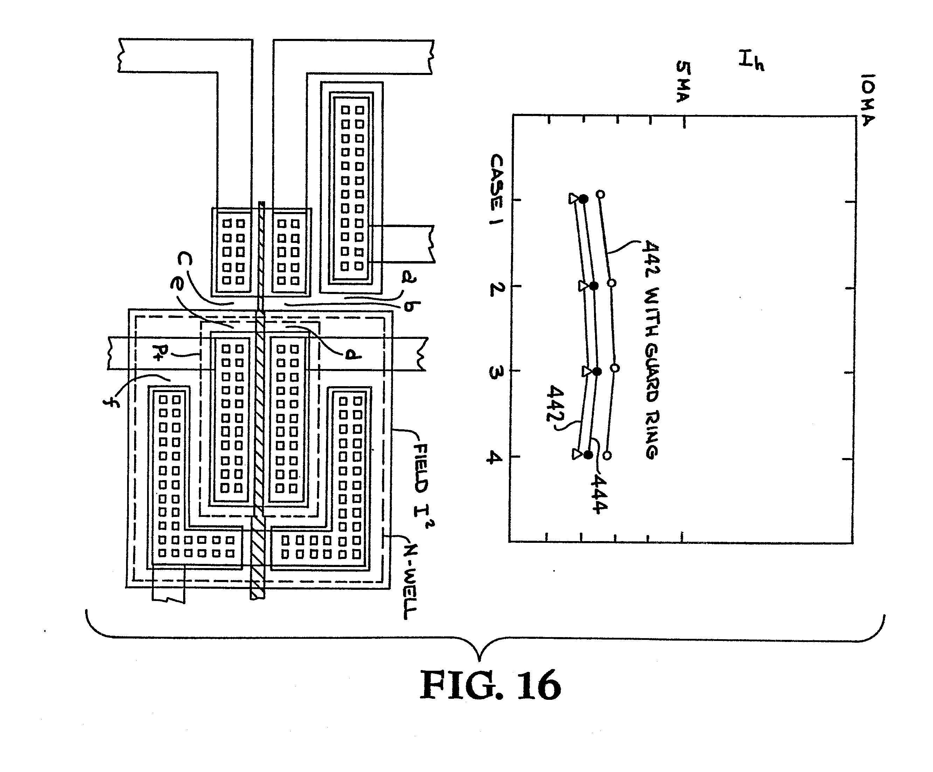

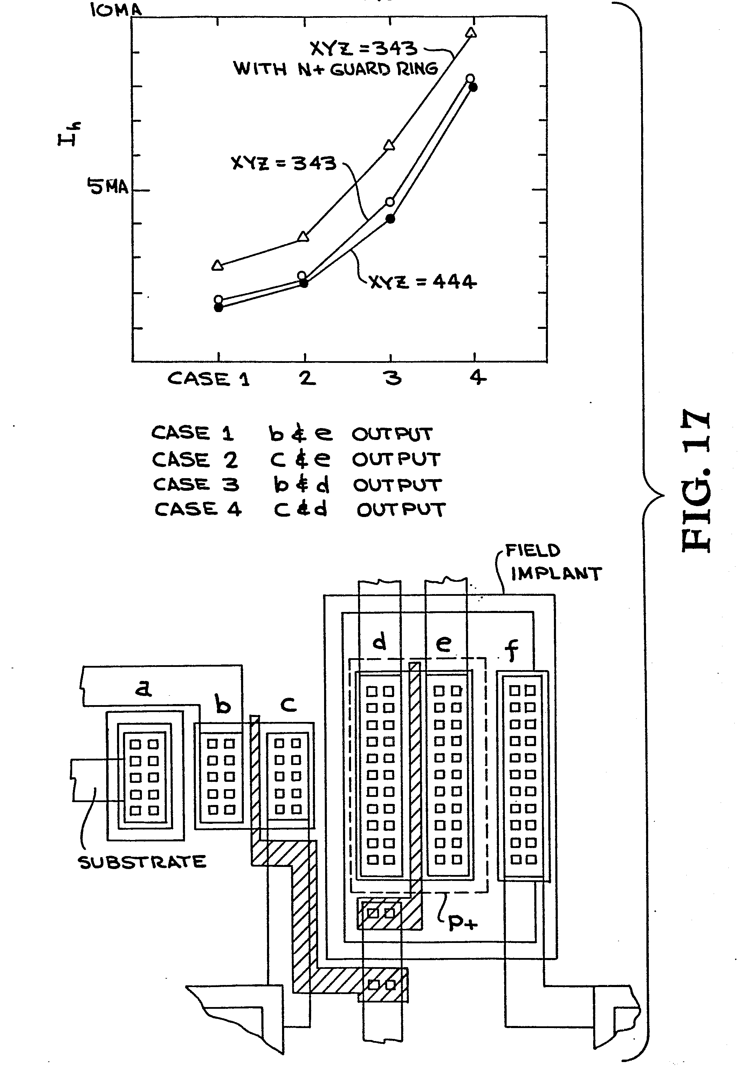

As shown throughout the embodiments in FIGURE 2, 4-6 and as further demonstrated in FIGURES 14 through 17, the resistance to latch-up is maximized when the circuit biasing potential, Vcc, and the circuit ground reference, Vss are supplied to the respective source regions 32 and 34 from metallization which outlies the structure, i.e. the electrodes are separated by the respective gate and drain regions of the structure. Moreover, the output of the device, Vout, when pulled from the drain regions 36, 38 at the center of the structure provides the device having the highest resistance to latch-up. FIGURES 16 and 17 show the empirical data obtained for a conventional layout and the present invention, respectively. Each case represents the pulling of Vout from the alphabetically labelled drain region alternatives.

The present invention is particularly suited to high voltage circuits such as EPROMs or EEPROMs which are particularly prone to latch-up.

The foregoing description of the preferred embodiment of the present invention has been presented for purposes of illustration and description. It is not intended to be exhaustive or to limit the invention to the precise form disclosed, and obviously many modifications and variations (such as to the sequence of the process steps) are possible in light of the above teaching. The embodiment was chosen and described in order to explain the principles of the invention and its practical application to thereby enable others skilled in the art to best utilize the invention in various embodiments and with various modifications as are suited to the particular use contemplated. It is intended that the scope of the invention be defined by both the claims appended hereto and their equivalents.

CLAIMS

What is claimed is:

1. A latch-up resistant integrated circuit device having a first transistor of a first conductivity type and a second transistor of a second conductivity type which is complementary to said first transistor, said transistors being electrically coupled, comprising:

said first transistor having its longitudinal axis lying in a first plane; and

said second transistor having its longitudinal axis lying in a second plane such that said first and second planes lie in an adjacently spaced parallel configuration,

whereby said integrated circuit device is highly resistant to latch-up.

2. In a CMOS integrated circuit device having a substrate and at least one p-channel transistor and at least one n-channel transistor coupled in a configuration wherein latch-up resistance is a function of the holding current, Ih, an improvement for increasing said latch-up resistance of said device characterized in that:

the drain regions of said transistors have their longitudinal axes lying in an adjacently spaced parallel configuration in said substrate;

the source regions of said transistors have their longitudinal axes lying in said substrate in a spaced parallel configuration and outlying at least a portion of said adjacently spaced drain regions; and

the gate regions of said transistors superpose said substrate and have their longitudinal axes lying in a spaced parallel configuration straddled by their respective source and drain planes.

3. The device as set forth in Claim 2, further characterized in that:

the output of said device is drawn from said drain regions between said gate regions.

4. A latch-up resistant complementary metal-oxide semiconductor (CMOS) integrated circuit comprising:

a substrate, having a first conductivity type;

a region, having a second conductivity type, embedded in said substrate;

a first region in said substrate, having said second conductivity type and defining a first source region;

a second region in said substrate adjacently spaced to said embedded region, having said second conductivity type and defining a first drain region adjacently spaced parallel to said first source region in said substrate and a first channel region therebetween;

a third region in said embedded region, having said first conductivity type and defining a second drain region adjacently spaced parallel to said first drain region in said substrate;

a fourth region in said embedded region distal to said second region in said substrate, having said first conductivity type and defining a second source region adjacently spaced parallel to said third region and a second channel region there between;

a first gate layer superposing said substrate and overlying said first channel region;

a second gate layer, parallel to said first gate layer, superposed on said embedded region and overlying said second channel region; and

interconnect means for electrically coupling said sources, drains and gates, such that said first and second regions and first gate layer form an MOS device of a one type and said third and fourth regions and second gate layer form a MOS device of a type complementary to said one type,

whereby said devices form a CMOS integrated circuit having increased latch-up resistance.

5. The circuit as set forth in Claim 4, further comprising:

interstitial dielectric layers between said first gate layer and said substrate and said second gate layer and said embedded region.

6. The circuit as set forth in Claim 5, wherein said interconnect means further comprises:

a first layer of a conducting material, patterned to form an electrode connecting said gate layers to an input signal;

a second layer of a conducting material connecting said drain regions, patterned to form an output electrode of said circuit;

a third layer of a conducting material, patterned to form an electrode connecting said first region to a biasing potential; and

a fourth layer of a conducting material patterned to form an electrode connecting said fourth region to a different biasing potential.

7.    A latch-up resistant complementary metal-oxide semiconductor (CMOS) integrated circuit, having a substrate, including a well of a conductivity type opposite that of said substrate, at least one p-channel transistor and at least one n-channel transistor, each having input and output terminals and one being located in said well comprising:

a first doped region in said substrate defining a source of said n-channel transistor;

a second doped region in said substrate defining a drain of said n-channel transistor, said first and second regions having their respective longitudinal axis lying in first parallel planes spaced to form a channel region of said n-channel transistor in said substrate therebetween;

a third doped region, adjacently spaced from said second doped region in said substrate, defining a drain for said p-channel transistor;

a fourth doped region in said substrate defining a source for said p-channel transistor, said third and fourth regions having their respective longitudinal axis lying in second parallel planes spaced to form a channel region of said p-channel transistor in said substrate therebetween, said second planes being mutually parallel with said first parallel planes;

a first gate layer superposing said channel region of said n-channel transistor;

a second gate layer superposing said channel region of said p-channel transistor, said first and second gate layers having their respective longitudinal axies lying in third parallel planes which are mutually parallel with said first and second parallel planes; and

interconnect means for electrically coupling said transistors.

8.    The circuit as set forth in Claim 7, further comprising:

an interstitial oxide layer between said gate layers and their respective channels.

9.   The circuit as set forth in Claim 8, wherein said oxide layer has a thickness in the range of appproximately 150 to 500 Angstroms.

10.   The circuit as set forth in Claim 8, wherein said interconnect means further comprises:

a thin film of conductive material superposed on said substrate, coupling said n-channel source to a circuit ground reference potential.

11.   The circuit as set forth in Claim 10, wherein said interconnect means further comprises:

a thin film of conductive material superposed on said substrate, coupling said p-channel source to a circuit biasing reference potential.

12.   The circuit as set forth in Claim 11, wherein said interconnect means further comprises:

a thin film of conductive material superposed on said substrate, coupling said first gate and said second gate to a circuit input signal.

13.   The circuit as set forth in Claim 12, wherein said interconnect means further comprises:

a thin film of conductive material superposed on said substrate forming an output electrode coupled to said n-channel drain.

14.   The circuit as set forth in Claim 13, wherein said interconnect means further comprises:

a thin film of conductive material superposed on said substrate forming an output electrode coupled to said p-channel drain.

15.   The circuit as set forth in Claim 14, wherein said p-channel drain and said n-channel drain are coupled.

16.   A method for fabricating a latch-up resistant integrated circuit device having a first transistor of a first conductivity type and a

second transistor of a second conductivity type which is complementary to said first transistor, comprising:

forming said first transistor to have its longitudinal axis lying in a first plane;

forming said second transistor to have its longitudinal axis lying in a second plane such that said first and second planes lie in an adjacently spaced parallel configuration,

whereby said circuit device is highly resistant to latch-up.

17.   A method for fabricating a latch-up resistant complementary metal-oxide semiconductor (CMOS) circuit in a substrate of a first conductivity type, comprising:

forming a region of a second conductivity type embedded in said substrate;

forming a first gate over said substrate and a second gate over said embedded region, such that said gates have their respective longitudinal axes lying in first parallel planes;

forming a first source region in said substrate on the side of said first gate which is furthest from said embedded region and forming a first drain region in said substrate on the side of said first gate electrode nearest said embedded region, such that said first source region and said first drain region have their respective longitudinal axes lying in second parallel planes which straddle the plane of said first gate;

forming a second drain region in said embedded region on the side of said second gate which is nearest said first drain region and forming a second source region in said embedded region on the side of said second gate distal from said first source region, such that said second drain region and said second source region have their respective longitudinal axes lying in third parallel planes which straddle the plane of said second dielectric gate,

whereby said first, second and third parallel plane are mutually parallel.

18.   The method as set forth in Claim 17, further comprising:

forming an interstitial dielectric layer between said first gate and said substrate; and

forming an interstitial dielectric layer between said second gate and said embedded region.

19. The method as set forth in Claim 18, wherein the step of forming interstitial dielectric layers further comprises:

forming said dielectric as a thin film of silicon dioxide.

20. The method as set forth in Claim 17, wherein the step of forming said first and second gate further comprises:

forming said gate of polysilicon.

21. The method as set forth in Claim 20, wherein the step of forming said first source and said first drain further comprises:

doping said regions of said substrate with ions of said second conductivity type.

22. The method as set forth in Claim 21, wherein the step of forming said second drain and said second source further comprises:

doping said regions of said embedded region with ions of said first conductivity type.

23. The method as set forth in Claim 22, further comprising:

forming electrodes to pull the output of said circuit from said drain regions.

24. A latch-up resistant CMOS circuit constructed in accordance with the method as set forth in Claim 22.

0197730

FIG. 1
(PRIOR ART)

FIG. 2A

FIG. 2B

0197730

## 2

$V_{CC}$

4 P-CHANNEL MOSFET

$V_{INPUT}$

$V_{OUTPUT}$

6 N-CHANNEL MOSFET

$V_{SS}$

# FIG. 3

22

28

46

$V_{OUT}$

34 42

40 32 30

38

36

44

SUBSTRATE PICK-UP | $V_{SS}$

$V_{CC}$

N WELL PICK-UP

$V_{IN}$

26 24

# FIG. 4A

SUBSTRATE PICK-UP

46

N WELL PICK-UP

$V_{OUT}$

$V_{SS}$

$V_{CC}$

30

42 40

34 38 36 32

44

$V_{IN}$

26 24

# FIG. 4 B

0197730

FIG. 5

FIG. 6

**FIG. 7**

**FIG. 8**

NITRIDE
BARRIER OXIDE

N-ch FIELD
IMPLANT

P-ch FIELD
IMPLANT

N    30

P-    28

## FIG. 9

FIELD OXIDE (FOX)

N    30

P-    28

## FIG. 10

FOX    FOX    FOX    FOX    FOX

N    30

P-    28

## FIG. 11

6/10

0197730

FIG. 12

FIG. 13

LAYOUT IMPACT ON $I_h$

FIG. 14

7/10

0197730

LAYOUT IMPACT ON $I_h$ (E$_{PI}$-WAFER)

$I_h$ (ma)

40

30

20

10

0

o AT 25°C
● AT 130°C

DOES NOT
LATCH AT 25°C

FIG. 2 DOES
NOT LATCH

FIG. 1
(PRIOR ART)

$V_{SS}$  $V_{cc}$  $V_{SS}$  $V_{cc}$  $V_{SS}$  $V_{cc}$  $V_{SS}$  $V_{cc}$

$V_{cc}$

$V_{SS}$

$V_{SS}$

$V_{cc}$

$V_{SS}$

← LAYOUT

FIG. 15

8/10

0197730

0197730

FIG. 16

10MA

$I_h$

5MA

442 WITH GUARD RING

444

442

CASE 1   2   3   4

a b

FIELD $I^2$

N-WELL

d

c e

P+

f

FIG. 17

CASE 1    b & e   OUTPUT
CASE 2    c & e   OUTPUT
CASE 3    b & d   OUTPUT
CASE 4    c & d   OUTPUT